# EUROPEAN PATENT SPECIFICATION

(11) **EP 0 704 312 B1**
(45) Date of publication and mention of the grant of the patent: **31.05.2000**
(21) Application number: 95115553.0
(22) Date of filing: 19.12.1991
(51) Int. Cl.: B41J 2/335, H01R 12/08

(54) **Thermal print head**
Thermodruckkopf
Tête d'impression thermique

(30) Priority: 28.12.1990 JP 40560390; 12.11.1991 JP 29541491 U
(43) Date of publication of application: 03.04.1996
(62) Divisional of application: 91121851.9
(73) Proprietor: ROHM CO., LTD., Kyoto (JP)
(72) Inventor: Ota, Shigeo, Ukyo-ku, Kyoto (JP); Ema, Yasushi, Ukyo-ku, Kyoto (JP)
(74) Representative: Reinhard - Skuhra - Weise & Partner

(56) References cited:
- WO-A-86/21131
- DE-U- 1 979 178
- FR-A- 1 579 427
- US-A- 3 528 050
- US-A- 3 825 884
- US-A- 4 416 497
- US-A- 4 555 715
- US-A- 4 701 002
- PATENT ABSTRACTS OF JAPAN vol. 12 no. 352 (M-744) ,21 September 1988 & JP-A-63 111064 (MITSUBISHI) 16 May 1988,

## Description

This invention relates to a pressing clip for pressing a flexible member against a circuit board. In particular, the present invention relates to a pressing a flexible cable against a line-type thermal print head which is used in a facsimile machine or printer for example.

The US 3,825,884 describes an electrical coupling device assigned for instantaneous manual coupling of a conductor such as an electrical conductor wire, to the conducting pin of an electrical apparatus of any type. The electrical coupling device has a cross-section in the general shape of a C and is formed in a metal strip or sheet having suitable elastic or spring characteristics. The body of the coupling device is generally cross-sectionally C-shaped, wherein the wings of said C-shape being close enough to the base of the C-shape to retain the pin in the conductor in direct pressurized contact. The wings each comprise a pair of tongues which are inclined with respect to the base, wherein each tongue has an end sloping outwardly from the base to aid insertion of the conductor and an opposed end sloping towards the base to provide a biting edge to resist removal of said conductor. The coupling device is adapted to establish an electrical connection between a single wire and a single terminal pin.

The US 3,528,050 describes a push-on type grounding clip used for connecting a single wire, conduit or the like to a wall of an electrical outlet box.

DE-U-19 79 178 describes a clamping member for connecting electrical wires having a metal strip, a portion of which is bent, wherein said portion comprises a through-hole for receiving a wire to be clamped.

A line-type terminal print head is conventional and disclosed for example in Japanese Utility Model Laid-open No. 60-141256 and 63-92751. The name "line-type thermal head" is given because it includes a multiplicity of heating dots disposed in a line arrangement.

Specifically, the line-type thermal head disclosed in either of the above-described Japanese publications comprises a head circuit board on which the line of heating dots is formed to extend longitudinally thereof. The head circuit board further carries a longitudinal array of drive IC's for driving the heating dots, and a conductor pattern which includes connection terminals arranged substantially over the entire length of the head circuit board.

The line-type thermal head further comprises a metallic support member for supporting the head circuit board thereon and for dissipating the heat therefrom during operation. A flexible connector board carrying a conductor pattern is partially overlapped on the head circuit board. Further, a presser cover arranged above the connector board is fixed to the support member by a plurality of bolts screwed in the support member for covering the array of drive IC's for protection. The underside of the presser cover is provided with a groove which receives a separate elastic rod for pressing the connector board into contact with the head circuit board when the bolts are tightened up.

According to the above-described arrangement, the connection terminals are distributed substantially over the entire length of the head circuit board. Thus, the presser cover need be bolted to the support member substantially over the entire length of the head circuit board, so that the presser cover and the support member cannot linearly expand independently of each other under heating. This results in that the thermal head is subjected to thermal bending due to the so-called "bimetal phenomenon", consequently causing deterioration of the printing quality.

Further, the conventional thermal print head is also disadvantageous in the following points.
(1) The separate elastic rod need be fitted in the groove of the presser cover at the time of assembling the thermal head. Thus, it is relatively time-taking to assemble the thermal head, which results in increase of the cost. Further, the use of the elastic rod adds to the total number of required components.
(2) The presser cover is a thick and rigid member which must be made by extrusion for example. Thus, the cost for making the presser member is relatively high. Further, the use of the presser cover adds greatly to the overall weight of the thermal head.
(3) To realize uniform contact between the flexible connector board and the head circuit board, the tightening force of all the bolts must be strictly controlled. Such necessity also adds greatly to the cost of the thermal head.

U.S. Patent No. 4,963,886 to Fukuda et al discloses another line-type thermal print head wherein the problematic thermal bending is prevented or reduced by arranging the connection terminals of the head circuit board in a limited central portion thereof while allowing the support member and the presser cover to linearly expand independently of each other at both ends of the thermal head. Although the problem of thermal bending is effectively prevented, the thermal head of this U.S. patent stills has the disadvantages (1)-(3) discussed above.

On the other hand, EP-A-0083419 discloses a printhead assembly wherein a support layer or circuit board is brought into direct electrical connection with a flexible flat cable by using a pair of clamping members which is held together by an elastic clip member (pressure applying means). Such a printhead assembly can be assembled conveninently with the use of the clip member.

However, the printhead assembly of EP-A-0083419 has been still disadvantageous in that the presence of the clip member prevents the flexible flat cable from extending to the circuit board directly from behind the clip member. Therefore, the flexible cable need be made to extend along an angular path for access to the clip member laterally thereof. Otherwise, the flexible cable need be made to extend along a curved path to circumvent the clip member for connection to the circuit board from ahead of the clip member.

It is, therefore, an object of the invention to provide a pressing clip which overcomes the above-described problems.

This object is achieved by a pressing clip having the features of claim 1.

Further preferable embodiments are claimed by the subclaims.

Other objects, features and advantages of the present invention will be fully understood from the following detailed description given with reference to the accompanying drawings, in which:
Fig. 1 is an exploded perspective view showing a thermal print head as an example for conveniently describing the present invention;
Fig. 1a is a side view showing a pressure applying spring incorporated in the thermal print head of Fig. 1;
Fig. 2 is a sectional view taken along lines II-II in Fig. 1;
Fig. 3 is a sectional view taken along lines III-III in Fig. 1 to show the thermal head in its assembled state;
Fig. 4 is a plan view showing the same thermal head;
Fig. 5 is a fragmentary perspective view showing a principal portion of the same thermal head in its exploded state;
Fig. 6 is a sectional view similar to Fig. 3 but showing a thermal print head as a second example for conveniently describing the present invention;
Fig. 7 is a perspective view showing a pressure applying spring as a third example for conveniently described the present invention;
Fig. 8 is a plan view showing a pressure applying spring as a fourth example for conveniently describing the present invention;
Fig. 9 is a perspective view showing a pressure applying spring as a fifth example for conveniently describing the present invention;
Fig. 10 is a perspective view showing a pressure applying spring as a sixth example for conveniently describing the present invention;
Figs. 11a is a sectional view showing a pressure applying spring as a seventh example for conveniently describing the present invention;
Fig. 11b is a sectional view similar to Fig. 11a but showing a pressure applying spring as an eighth example for conveninently describing the present invention;
Fig. 12 is a perspective view showing a thermal print head as a ninth example for conveniently describing the present invention;
Figs. 13 is a perspective view showing a thermal print head as a tenth example for conveniently describing the present invention;
Fig. 14 is a sectional view taken along lines X-X in Fig. 13;
Fig. 14a is a side view showing a pressure applying clip incorporated in the thermal head shown in Fig. 14;
Figs. 15 and 16 are perspective views showing pressure applying clips as eleventh and twelfth examples, respectively, for conveniently describing the present invention;
Fig. 17 is a perspective view showing a thermal print head according to a first embodiment of the invention;
Fig. 18 is a sectional view taken along lines XVIII-XVIII in Fig. 17;
Fig. 19 is an enlarged perspective view showing a pressure applying clip incorporated in the thermal head of the first embodiment; and
Fig. 20 is a sectional view similar to Fig. 18 but showing a thermal print head according to a second embodiment of the present invention.

Throughout the accompanying drawings, like parts are designated by the same reference numerals and characters.

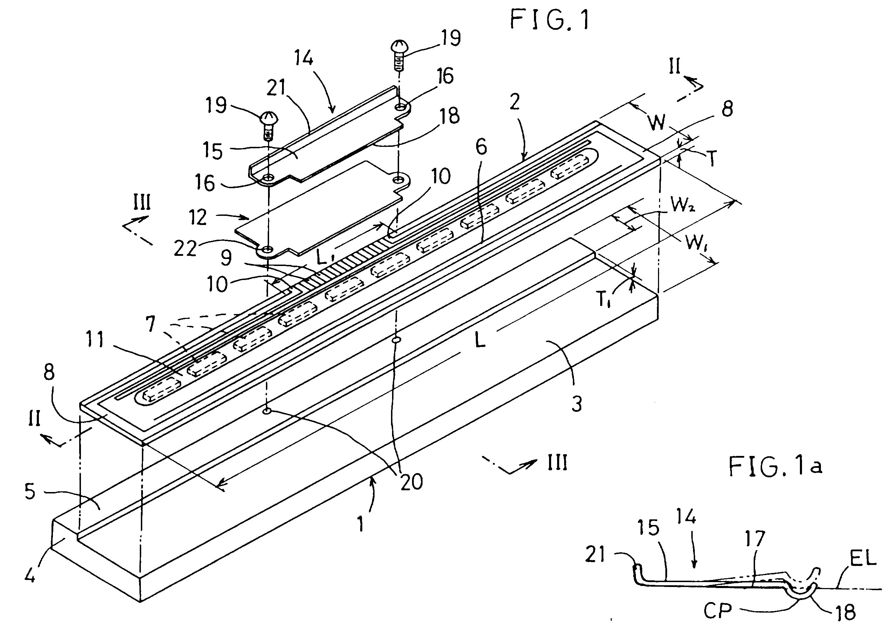

Figs. 1 through 5 show a line-type thermal print head as a first example which is not the present invention in itself but useful for better understanding of the present invention to be described later. The print head mainly comprises an elongate support plate 1, an elongate head circuit board 2 mounted on the support plate 1, a flexible connector board 12 partially overlapped over the head circuit board 2, and a pressure applying member 14 for pressing, from above, the flexible connector board 12 into intimate contact with the head circuit board 2.

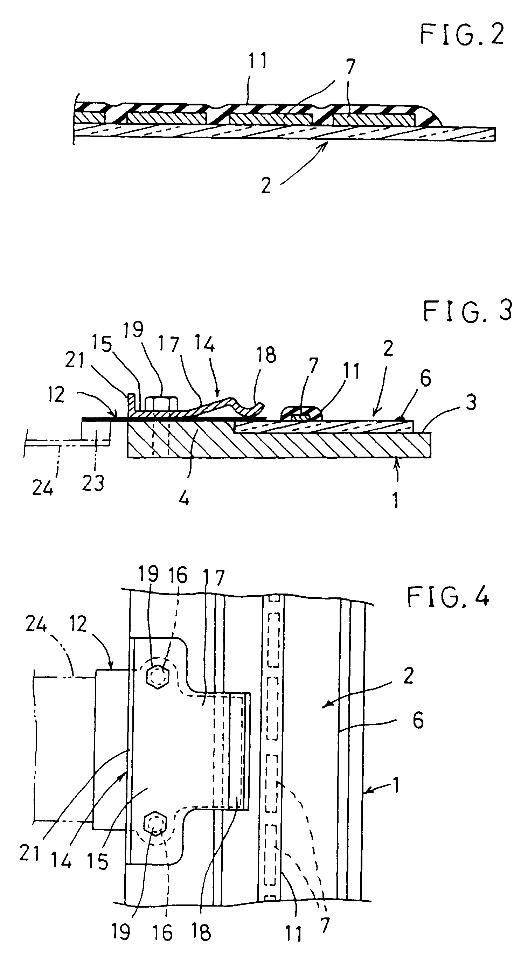

The support plate 1 is made of aluminum for example and works also as a heat sink. As shown in Fig. 1, the support plate has a width W1 which is larger than the width W of the head circuit board 2 by an amount W2. The support plate provides an upper support surface 3 on which the head circuit board 2 is placed. The support plate also has an excess marginal portion 4 which extends beyond the upper support surface 3 (and the head circuit board 2 supported thereon). The excess marginal portion 4 provides a raised surface 5 which is higher than the support surface 3 by an amount T1 corresponding to the thickness T of the head circuit board 2. Thus, when the head circuit board 2 is placed on the support surface 3, the raised surface 5 becomes flush with the upper surface of the head circuit board 2, as best shown in Fig. 3.

The head circuit board 2 carries a heating resistor line 6 extending longitudinally thereof to provide a line of multiple heating dots. The head circuit board also carries a longitudinal array of drive IC's 7 for divisionally heating the resistor line 6. The array of drive IC's 7 is completely enclosed in an elongate protective body 11 made of relatively hard synthetic resin (e.g. epoxy resin) , as shown in Figs. 2 and 3.

Further, the upper surface of the head circuit board 2 is formed with a conductor pattern which includes a common electrode 8 extending along the respective edges of the circuit board, connection terminals 9, and other pattern elements such as individual electrodes (not shown). The common electrode 8 has a pair of connection terminals 10 which constitute a comb-like arrangement together with the other connection terminals 9. These connection terminals 9, 10 are used for receiving drive power and various signals (e.g. clock signals, latch signals and so on) from the exterior. According to the illustrated example, the connection terminals 9, 10 are disposed locally in a limited central portion whose length L1 is sufficiently smaller than the overall length L of the head circuit board.

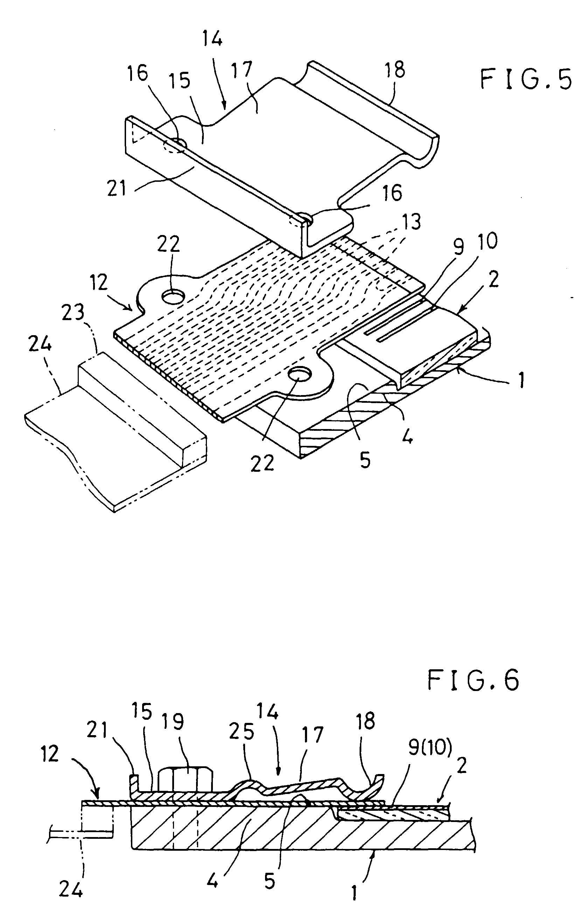

The flexible connector board 12 is formed with a wiring conductor pattern 13 (see Fig. 5) for electrical connection to the connection terminals 9, 10 of the head circuit board 2. In assembly, the connector board 12 rests on the raised surface 5 of the support member 1 but project beyond the raised surface 5 to partially overlap the head circuit board 2 in the central portion L1 thereof, as best shown in Fig. 3. Obviously, the raised surface 5 of the support member 1 provides a support for the connector board 12, so that no separate reinforcing backing is required for the connector board in spite of its flexibility. As shown in Figs. 3 through 5, the underside of the connector board 12 carries a connector 23 which is removably connected to a band-like flexible cable 24 for electrical conduction.

As better shown in Figs. 3 through 5, the pressure applying member 14 according to the first example is in the form of a plate spring having a base portion 15 provided with a pair of mounting holes 16. The base portion 15 is also provided with a reinforcing rib 21 which is formed by upwardly bending a margin of the base portion. The pressure applying spring 14 further has an integral extension 17 formed with a rounded presser tip portion 18 for pressing the overlapping portion of the flexible connector board 12 into intimate contact with the head circuit board 2 in the central portion L1 thereof. The presser tip portion 18 is rounded to avoid damage to the flexible connector board 12 due to direct contact therewith.

For the purpose of mounting the pressure applying spring 14, a pair of perforations 22 are formed in the flexible connector board 12 in corresponding relation to the mounting holes 16 of the pressure applying spring, and a pair of threaded holes 20 are formed in the excess marginal portion 4 of the support member 1 again in corresponding relation to the spring mounting holes 16. Bolts 19 are inserted through the mounting holes 16 and the perforations 22 into engagement with the threaded holes 20.

In natural state, the base portion 15 and integral extension 17 of the pressure applying spring 14 are contained in a same plane EL, as indicated by solid lines in Fig. 1a. However, as the bolts 15 are tightened up, the pressure applying spring 14 is elastically deformed. As a result, the integral extension 17 deviates from the plane EL of the base portion 15, as indicated by phantom lines in Fig. 1a. Instead, a contact line CP provided by the rounded presser tip portion 18 will be located in the plane of the base portion 15.

In this way, the elastic restoring force of the pressure applying spring 14 can be effectively utilized for causing the rounded presser tip portion 18 to press the conductor pattern 13 of the flexible connector board 12 into uniform and intimate contact with the respective connection terminals 9, 10 of the head circuit board 2. According to the first example, the following advantages are also obtainable in addition to this basic advantage.
(1) The pressure applying plate spring 14 may be made relatively thin for positive utilization of its elasticity. Thus, the plate spring can be made by press-working a sheet metal at a lower cost than a rigid aluminum presser cover which must be made by extrusion or forging. Further, the overall thickness and weight of the thermal print head can be correspondingly reduced.
(2) Since the elastic restoring force of the plate spring 14 is positively utilized for pressure application, the bolts 19 for mounting the spring 14 need only be tightened up until the base portion 15 of the spring comes into intimate contact with the flexible connector board 12. Thus, the tightening force of the bolts 19 need not be strictly controlled, so that the plate spring 14 can be mounted extremely easily.
(3) Since the elastic restoring force of the plate spring 14 itself is utilized for pressure application, no separate elastic member is needed (cf. the elastic rod of U.S. Patent No. 4,963,886). Thus, the total number of required components can be reduced, and the time and labor required for assembly are also reduced correspondingly for production cost reduction.
(4) The reinforcing rib 21 increases the rigidity of the base portion 15 of the plate spring 14. This reinforcing rib prevents warping (lifting) of the spring base portion 15 at a position between the bolts 19 at the time of elastically deforming the spring 14 (see Fig. 1a). As a result, the plate spring 14 is rendered capable of providing even more uniform pressure application relative to the connector board 12.
(5) The support member 1 itself has a raised surface 5 to provide a support for the flexible connector board 12. Thus, no separate backing or reinforcement is needed for the connector board, thereby reducing the total number of required components.

Fig. 6 shows a thermal print head as a second example which is not the present invention in itself but useful for better understanding of the present invention to be described hereinafter. The second example differs from the first example only in that the pressure applying plate spring 14 additionally has a reinforcing bulge 25 extending longitudinally of the support member 1. The reinforcing bulge 25 is positioned between the base portion 15 and the integral extension 17.

Obviously, the reinforcing bulge 25 provided in the second example cooperates with the reinforcing rib 21 to further increase the rigidity of the spring base portion, thereby effectively preventing warping (lifting) at an intermediate position between the bolts 19 to enable uniform contact between the flexible connector board 12 and the head circuit board 2. Of course, the reinforcing bulge 25 alone is effective for reinforcement, so that the reinforcing rib 21 may be dispensed with.

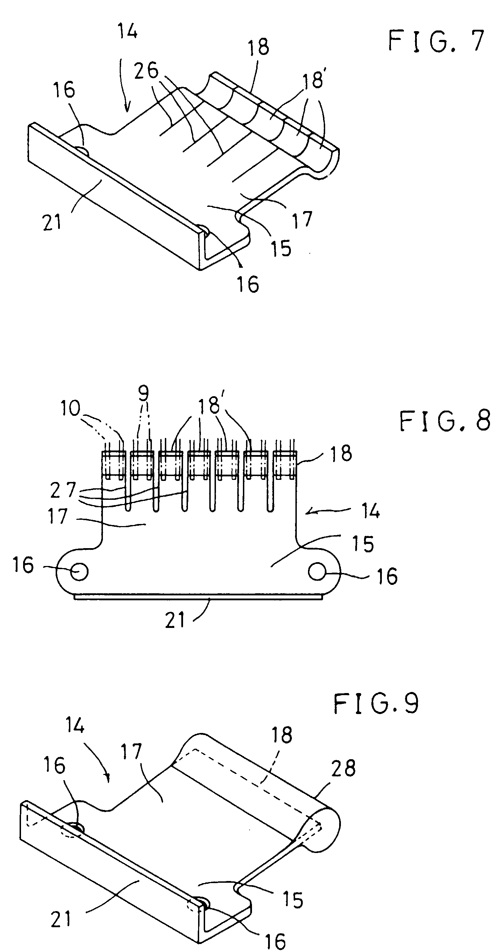

Fig. 7 illustrates a pressure applying plate spring 14 as a third example which is not the present invention in itself but useful for better understanding of the present invention to be described later. The plate spring 14 of this example differs from that of the first example only in that the integral extension 17 is formed with a plurality of cuts 26 to divide the integral extension 17 together with the presser tip portion 18 into segments 18' which are elastically deformable independently of each other.

According to the third example, independent deformability of the respective divided segments 18' insures substantially uniform contact between the flexible connector board 12 (namely, the conductor pattern 13 shown in Fig. 5) and the head circuit board 2 (namely, the connection terminals 9, 10) even if the flexible connector board 12 and/or the head circuit board 2 are irregular in thickness longitudinally thereof. Thus, it is possible to always obtain reliable electrical connection between the flexible connector board 12 and the head circuit board 2.

Fig. 8 shows a pressure applying plate spring 14 as a fourth example which is not the present invention in itself but useful for better understanding of the present invention to be described later. The plate spring 14 of this example differs from that of the third example only in that the cuts 26 shown in Fig. 7 are replaced by slits 27. Obviously, the fourth example enjoys the same advantage as the third example.

Fig. 9 shows a pressure applying plate spring 14 as a fifth example which is not the present invention in itself but useful for better understanding of the present invention to be described later. According to this example, the plate spring 14 has a presser tip portion 18 enclosed in a relatively soft elastic body 28 which is made of rubber for example. The elastic body 28 is irremovably attached to the presser tip portion 18 by molding in situ with the tip portion 18. Thus, the elastic body 28 is substantially integral with the presser tip portion 18 and therefore does not constitute an additional element, as opposed to the separate rubber rod disclosed in U.S. Patent No. 4,963,886.

Obviously, the elastic body 28 provides a soft contact relative to the flexible connector board 12 (see Fig. 3 for example) without likelihood of damaging it. Further, the elastic body 28 can easily follow the surface irregularities of the flexible connector board 12, thereby insuring reliable electrical connection between the flexible connector board 12 and the head circuit board 2.

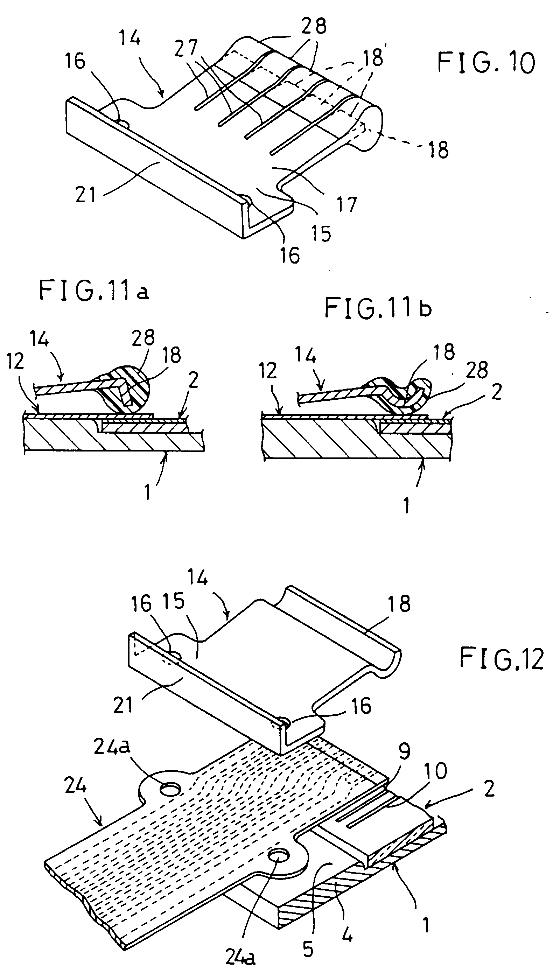

Similarly to the third and fourth examples shown in Figs. 7 and 8, the integral extension 17 of the pressure applying plate spring 14 together with the elastic body 28 may be divided by a plurality of slits 27 (or alternatively, cuts), as shown in Fig. 10 (sixth example which is not the present invention). Further, the presser tip portion 18 of the pressure applying plate spring 14 may be downwardly directed or arcuately curved and enclosed in an elastic body 28 of an optional shape, as shown in Fig. 11a (seventh example which is not the present invention) or Fig. 11b (eighth example which is not the present invention).

Fig. 12 illustrates a thermal print head as a ninth example which is not the present invention in itself but useful for better understanding of the present invention. The thermal print head of this example is similar to that of the first example but differs therefrom only in that the band-like flexible cable 24 is directly connected to the head circuit board 2 without utilizing the flexible connector board 12 and the socket-type connector 23 (see Fig. 3). Thus, the pressure applying plate spring 14 is made to directly press the front end portion of the flexible cable 24 into contact with the head circuit board 2. For enabling fixation to the support member 1, the flexible cable 24 is formed with a pair of perforations 24a in corresponding relation to the mounting holes 16 of the plate spring 14.

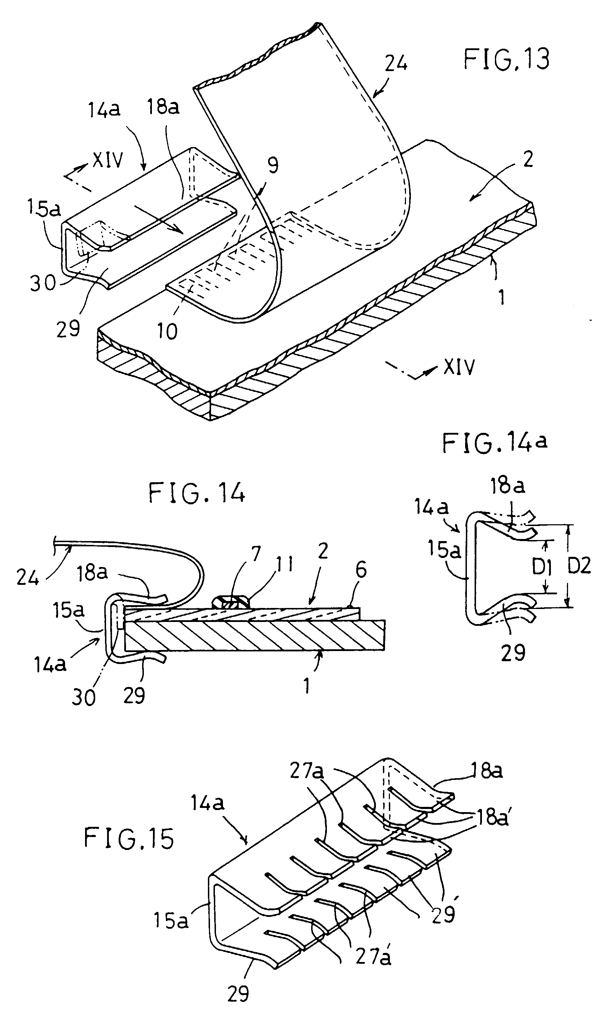

Figs. 13 through 14a show a thermal print head as a tenth example which is not the present invention in itself but useful for better understanding of the present invention. According to the tenth example, use is made of a pressure applying member 14a which is in the form of a clip or channel which is elastically mountable by its own clipping function. Thus, there is no need to use any separate fixing means such as bolts, and the support member 1 supporting the head circuit board 2 is not required to have an excess marginal portion (see reference numeral 4 in Fig. 1) for the provision of threaded holes (see reference numeral 20 in Fig. 1). As a result, the width of the support member 1 may be correspondingly reduced, as shown in Figs. 13 and 14.

The pressure applying clip 14a, which can be regarded to constitute a plate spring as a whole, has a base or web portion 15a. The clip further has a presser portion 18a with a rounded tip for directly pressing the band-like flexible cable 24, and an anchoring portion 29 also with a rounded tip for engaging the underside of the support member 1. As shown in Figs. 13 and 14, the front end portion of the flexible cable 24 is bent and turned over before being nipped by the clip 14a.

In natural state of the clip, the distance D1 (see Fig. 14a) between the presser portion 18a and the anchoring portion 29 is smaller than the combined thickness of the support member 1, head circuit board 2 and band-like flexible cable 24. However, when the clip is mounted for clipping, the distance between the presser portion 18a and the anchoring portion 29 increases to a value D2 corresponding to the combined thickness by elastic deformation of the clip, as indicated by phantom lines in Fig. 14a.

Obviously, the clip 14a thus mounted is capable of insuring substantially uniform contact between the flexible cable 24 and the head circuit board 2. Further, the clip 14a need only be fitted without using any bolts, so that it is possible to greatly reduce the time and labor required for mounting the clip in addition to reducing the required number of components.

Preferably, the presser portion 18a may be provided with a positioning stopper 30 which is formed by downwardly bending a part of the presser portion, as indicated by phantom lines in Figs. 13 and 14. This stopper 30 comes into abutment with the support member 1 at the time of fitting, thereby accurately positioning the clip 14a relative to the head circuit board 2 transversely thereof. Alternatively, the anchoring portion 29 may be provided with a similar positioning stopper (not shown) by upwardly bending a part of the anchoring portion.

The presser portion 18a of the pressure applying clip 14a may be formed with a plurality of slits 27a for division into segments 18a', as shown in Fig. 15 (eleventh example which is not the present invention). The advantages obtainable by the provision of such slits are already described in connection with Figs. 7 and 8. Similarly, the anchoring portion 29 may be formed with a plurality of slits 27a' for division into segments 29', as also shown in Fig. 15.

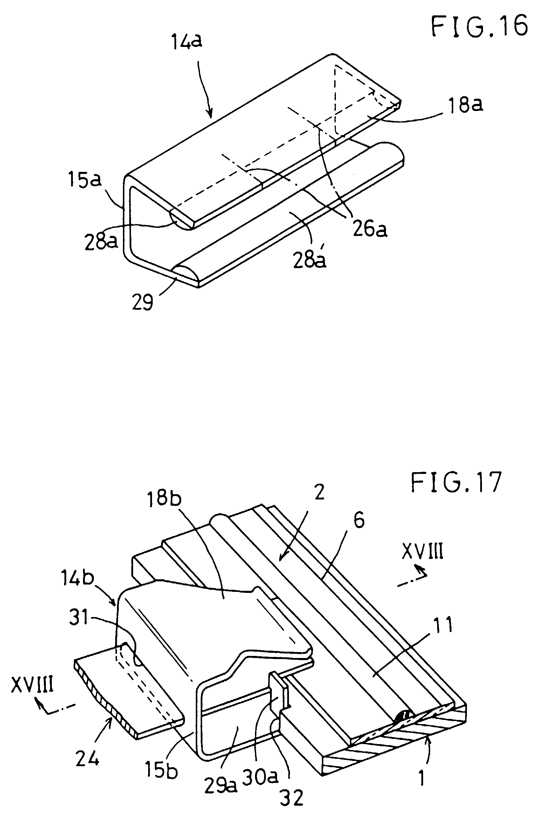

Further, the presser portion 18a of the pressure applying clip 14a may be provided with a relatively soft elastic body 28a which is made of rubber for example, as shown in Fig. 16 (twelfth example which is not the present invention). The elastic body 28a provides an advantage of preventing unexpected removal of the clip 14a due to increased frictional resistance in addition to the advantages which are already described in connection with Fig. 9. Similarly, the anchoring member 29 may also be provided with a relatively soft elastic body 28a'. Further, the presser member 18a may be formed with a plurality of cuts 26a for division into independently deformable segments.

Figs. 17 through 19 represent a thermal print head according to a first embodiment of the present invention which is typically based on the examples shown in Figs. 13 to 16. According to this embodiment, use is made of an improved pressure applying clip 14b which enables the band-like flexible cable 24 to be led to its clipped position from behind the clip.

Similarly to the examples shown in Figs. 13 to 16, the improved pressure applying clip 14b has a base or web portion 15b, a presser portion 18b, and an anchoring portion 29a. The web portion 15b has an access opening 31 to allow entry, from behind, of the flexible cable 24 to its clipped position. If necessary, this access opening 31 may be utilized also for allowing entry of a flexible connector board (see reference numeral 12 in Figs. 4 and 5 for example) for connection to the flexible cable 24.

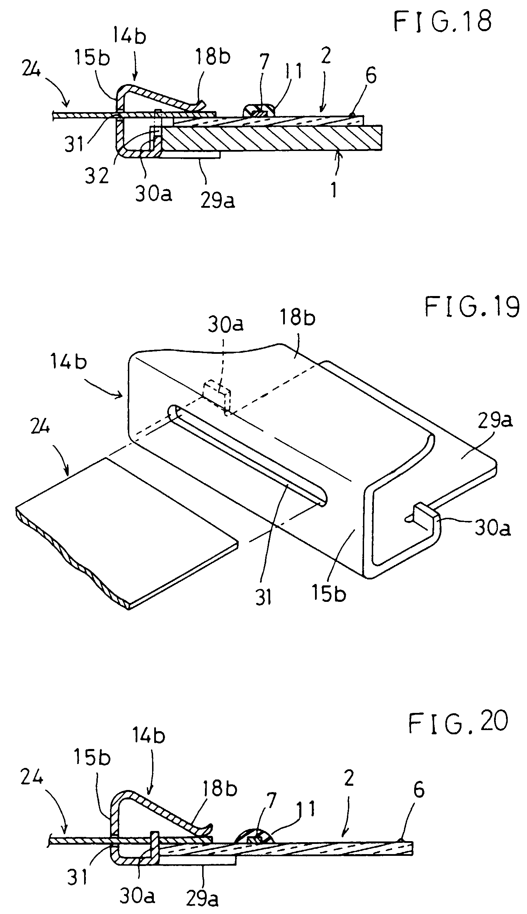

Further, according to the first embodiment of the present invention shown in Figs. 17 to 19, the anchoring portion 29a is made to have a pair of positioning stoppers 30a which come into abutment with the support member 1 when the clip 14b is mounted suitably relative to the support member transversely thereof. Preferably, the support member 1 is formed with a positioning cutout 32 in which the stoppers 30a are fitted in for preventing positional deviation of the clip 14b longitudinally of the support member 1. It is further advantageous if the stoppers 30a have a sufficient height as to prevent positional deviation of the flexible cable 24 longitudinally of the support member 1, as shown in Fig. 17. It should be appreciated that the stoppers 30a are shown to have a smaller height in Figs. 18 and 19 than in Fig. 17, such illustration being only for purposes of comparison.

Obviously, the presser portion 18b of the improved clip 14b may be formed with slits or cuts (see Figs. 15 and 16). Further, each of the presser portion 18b and anchoring portion 29a may be provided with a relatively soft elastic member (see Fig. 16) to prevent damaging contact with a counterpart component.

Fig. 20 shows a thermal print head according to a second embodiment which is substantially identical to the first embodiment but differs therefrom only in that the anchoring portion 29a of the clip 14b is made to directly engage the underside of the head circuit board 2. Thus, no support member is used in the thermal print head of the fourteenth embodiment.

Obviously, the arrangement shown in Fig. 20 is simpler and requires a smaller number of components, consequently resulting in great reduction in cost and weight of the print head. It should be appreciated that a mounting plate (not shown), which is originally incorporated in a facsimile machine for example, may be utilized for supporting the head circuit board 2 and for dissipating the heat therefrom.

The invention being thus described, it is obvious that the same may be varied in many ways.

## Claims

1. A pressing clip for pressing a band-like flexible cable (24) against a circuit board (2) into electrical contact with a plurality of connection terminals (9, 10) formed on the circuit board (2), the pressing clip comprising:
a web portion (15b);
a presser portion (18b) extending from the web portion (15b), the presser portion (18b) being elastically deformable for pressing the flexible cable (24); and
an anchoring portion (29a) also extending from the web portion (15b) in facing relation to the presser portion (18b), the anchoring portion (29a) and the presser portion (18b) forming a clipping clearance therebetween for receiving the circuit board (2) and the flexible cable (24);
characterized in
that the web portion (15b) is formed with an elongated access opening (31) through which the flexible cable (24) extends for insertion into the clipping clearance; and that the clip member is wider than the flexible cable (24).

2. The pressing clip according to claim 1, wherein the anchoring portion (29a) is formed with stopper means (30a) for accurately positioning the pressing clip (14b) relative to the circuit board (2) .

3. The pressing clip according to claim 2, wherein the circuit board (2) is mounted on a support member (1) formed with a positioning cutout (32) for receiving the stopper means (30a) to accurately position the pressing clip (14b) relative to the circuit board (2) longitudinal thereof.

4. The pressing clip according to claim 2 or 3, wherein the stopper means (30a) comprises a pair of positioning stoppers between which the flexible cable (24) extends, the positioning stoppers (30a) limiting displacement of the flexible cable (24) widthwise thereof.

5. The pressing clip according to claim 3 oder 4, wherein the anchoring portion (29a) being made to engage the support member (1) .

6. The pressing clip according to claim 1 or 2, wherein the anchoring portion (29a) is made to directly engage the circuit board (2).

## Patentansprüche

1. Druckklemme zum Pressen eines bandähnlichen flexiblen Kabels (24) gegen eine Leiterplatte (2) in elektrischen Kontakt mit zahlreichen Verbindungsanschlüssen (9, 10), die auf der Leiterplatte (2) gebildet sind, wobei zu der Druckklemme gehören:
ein flacher Seitenabschnitt (15b);
ein Druckabschnitt (18b), der sich von dem flachen Seitenabschnitt (15b) erstreckt, wobei der Druckabschnitt (18b) zum Druckbeaufschlagen des flexiblen Kabels (24) elastisch deformierbar ist; und
ein Verankerungsabschnitt (29a), der sich ebenfalls von dem flachen Seitenabschnitt (15b) in auf den Druckabschnitt weisender Zuordnung erstreckt, wobei der Verankerungsabschnitt (29a) und der Druckabschnitt (18b) zwischen sich eine Klemmenaussparung zur Aufnahme der Leiterplatte (2) und des flexiblen Kabels (4) bilden;
**dadurch gekennzeichnet**,
daß der flache Seitenabschnitt (15b) mit einer länglichen Zugangsöffnung (31) gebildet ist, durch die sich das flexible Kabel (24) zum Einsetzen in die Klemmenaussparung erstreckt; und daß das Klemmenelement breiter ist als das flexible Kabel (24).

2. Druckklemme nach Anspruch 1, wobei der Verankerungsabschnitt mit einer Anschlageinrichtung (30a) für das genaue Positionieren der Druckklemme (14b) bezüglich der Leiterplatte (2) gebildet ist.

3. Druckklemme nach Anspruch 2, bei der die Leiterplatte (2) auf einem Halteteil (1) montiert ist, welches mit einem Positionierausschnitt (32) zur Aufnahme der Anschlageinrichtung (30a) zum genauen Positionieren der Druckklemme (14b) bezüglich der Leiterplatte (2) in länglicher Richtung zu dieser gebildet ist.

4. Druckklemme nach Anspruch 2 oder 3, wobei die Anschlageinrichtung (30a) ein paar Positionieranschläge aufweist, zwischen denen sich das flexible Kabel (24) erstreckt, wobei die Positionieranschläge (30a) die Verlagerung des flexiblen Kabels (24) in dessen Breitenrichtung begrenzen.

5. Druckklemme nach Anspruch 3 oder 4, bei der der Verankerungsabschnitt (29a) für den Eingriff in das Halteteil (1) hergestellt ist.

6. Druckklemme nach Anspruch 1 oder 2, bei der der Verankerungsabschnitt (29a) für den direkten Eingriff in die Leiterplatte (2) hergestellt ist.

## Revendications

1. Agrafe de pression pour presser un câble souple de type ruban (24) contre une plaquette de circuit (2), en contact électrique avec une pluralité de bornes de connexion (9,10) formées sur la plaquette de circuit (2), l'agrafe de pression comprenant :
une partie de base (15b) ;
une partie de pression (18b) s'étendant à partir de la partie de base (15b), la partie de pression (18b ) étant élastiquement déformable pour presser le câble souple (24) ; et
une partie d'ancrage (29a) s'étendant également à partir de la partie de base (15b) en vis-à-vis de la partie de pression (18b), la partie d'ancrage (29a) et la partie de presssion (18b) définissant entre elles un espace de pincement pour recevoir la plaquette de circuit (2) et le câble souple (24) ;
caractérisée en ce que la partie de base (15b) comporte une ouverture d'accès allongée (31) à travers laquelle le câble souple (24) passe pour insertion dans l'espace de pincement, et en ce que l'agrafe est plus large que le câble souple (24).

2. Agrafe de pression selon la revendication 1, dans laquelle des éléments d'arrêt (30a) sont formés sur la partie d'ancrage (29a) pour positionner exactement l'agrafe de pression (14b) par rapport à la plaquette de circuit (2).

3. Agrafe de pression selon la revendication 2, dans laquelle la plaquette de circuit (2) est montée sur un support (1) comportant une découpe de positionnement (32) pour recevoir les éléments d'arrêt (30a) afin de positionner exactement l'agrafe de pression (14b) par rapport à la plaquette de circuit (2) dans sa direction longitudinale.

4. Agrafe de pression selon la revendication 2 ou 3, dans laquelle les éléments d'arrêt (30a) comprennent deux éléments d'arrêt et de positionnement entre lesquels s'étend le câble souple (24), les éléments d'arrêt et de positionnement (30a) limitant le déplacement du câble souple (24) dans le sens de sa largeur.

5. Agrafe de pression selon la revendication 3 ou 4, dans laquelle la partie d'ancrage (29a) est prévue pour venir en prise avec le support (1).

6. Agrafe de pression selon la revendication 1 ou 2,dans laquelle la partie d'ancrage (29a) est prévue pour venir directement en prise avec la plaquette de circuit (2).
